# EUROPEAN PATENT SPECIFICATION

(11) **EP 2 135 251 B1**
(45) Date of publication and mention of the grant of the patent: **14.06.2017**
(21) Application number: 08744037.6
(22) Date of filing: 19.03.2008
(51) Int. Cl.: G11C 16/10, G11C 16/34

(54) **FLASH MEMORY REFRESH TECHNIQUES TRIGGERED BY CONTROLLED SCRUB DATA READS**
MITTELS GESTEUERTER BEREINIGUNGSDATENLESUNG AUSGELÖSTE AKTUALISIERUNGSVERFAHREN FÜR EINEN FLASH-SPEICHER
TECHNIQUES DE RAFRAÎCHISSEMENT DE MÉMOIRE FLASH DÉCLENCHÉES PAR DES LECTURES CONTRÔLÉES DE DONNÉES À NETTOYER

(30) Priority: 28.03.2007 US 692840; 28.03.2007 US 692829
(43) Date of publication of application: 23.12.2009
(73) Proprietor: SanDisk Technologies LLC, Plano, Texas 75024 (US)
(72) Inventor: LIN, Jason, T., Santa Clara, California 95051 (US)
(74) Representative: Prock, Thomas
(86) International application number: PCT/US2008/057422
(87) International publication number: WO 2008/118705

(56) References cited:
- US-A- 5 715 193
- US-A1- 2005 073 884

## Description

### BACKGROUND

The subject matter herein relates generally to techniques of refreshing data stored in re-programmable non-volatile memory, and, more specifically, to the correction and refresh of stored data in response to potential disturbs of the data that can be caused by reading other data.

There are many commercially successful non-volatile memory products being used today, particularly in the form of small form factor cards and flash drives with an interface according to the Universal Serial Bus (USB) standard. They individually employ an array of flash EEPROM (Electrically Erasable and Programmable Read Only Memory) cells formed on one or more integrated circuit chips. A memory controller, usually but not necessarily on a separate integrated circuit chip, interfaces with a host to which the card is removably connected and controls operation of the memory array within the card. Such a controller typically includes a microprocessor, some non-volatile read-only-memory (ROM), a volatile random-access-memory (RAM) and one or more special circuits such as one that calculates an error-correction-code (ECC) from data as they pass through the controller during the programming and reading of data.

Examples of such memory cards are those sold by SanDisk Corporation, the assignee hereof, under the trademarks CompactFlash™ (CF) cards, MultiMedia cards (MMC), Secure Digital (SD) cards, miniSD cards, micro SD cards, TransFlash cards and Memory Stick cards. Several different USB flash drives are available from SanDisk under its Cruzer trademark. Hosts include personal computers, notebook computers, personal digital assistants (PDAs), various data communication devices, digital cameras, cellular telephones, portable audio players, automobile sound systems, and similar types of equipment. Besides the memory card and flash drive formats, this type of memory system can alternatively be embedded into various types of host systems. Many types of memory cards and flash drives are capable of executing application programs alone, or in conjunction with a host.

Two general memory cell array architectures have found commercial application, NOR and NAND. In a typical NOR array, memory cells are connected between adjacent bit line source and drain diffusions that extend in a column direction with control gates connected to word lines extending along rows of cells. A memory cell includes at least one storage element positioned over at least a portion of the cell channel region between the source and drain. A programmed level of charge on the storage elements thus controls an operating characteristic of the cells, which can then be read by applying appropriate voltages to the addressed memory cells. Examples of such cells, their uses in memory systems and methods of manufacturing them are given in United States patents nos. 5,070,032, 5,095,344, 5,313,421, 5,315,541, 5,343,063, 5,661,053 and 6,222,762.

The NAND array utilizes series strings of more than two memory cells, such as 16 or 32, connected along with one or more select transistors between individual bit lines and a reference potential to form columns of cells. Word lines extend across cells within a large number of these columns. An individual cell within a column is read and verified during programming by causing the remaining cells in the string to be turned on hard so that the current flowing through a string is dependent upon the level of charge stored in the addressed cell. Examples of NAND architecture arrays and their operation as part of a memory system are found in United States patents nos. 5,570,315, 5,774,397, 6,046,935, and 6,522,580.

The charge storage elements of current flash EEPROM arrays, as discussed in the foregoing referenced patents, are most commonly electrically conductive floating gates, typically formed from conductively doped polysilicon material. An alternate type of memory cell useful in flash EEPROM systems utilizes a non-conductive dielectric material in place of the conductive floating gate to store charge in a non-volatile manner. The cell is programmed by causing electrons from the cell channel to move into the dielectric, where they are trapped and stored in a limited region. Several specific cell structures and arrays employing dielectric storage elements and are described in United States patent no. 6,925,007.

As in most all integrated circuit applications, the pressure to shrink the silicon substrate area required to implement some integrated circuit function also exists with flash EEPROM memory cell arrays. It is continually desired to increase the amount of digital data that can be stored in a given area of a silicon substrate, in order to increase the storage capacity of a given size memory card and other types of packages, or to both increase capacity and decrease size. One way to increase the storage density of data is to store more than one bit of data per memory cell and/or per storage unit or element. This is accomplished by dividing a window of a storage element charge level voltage range into more than two states. The use of four such states allows each cell to store two bits of data, eight states stores three bits of data per storage element, and so on. Multiple state flash EEPROM structures using floating gates and their operation are described in United States patents nos. 5,043,940 and 5,172,338, for example, and aforementioned United States patent no. 6,925,007 describes structures using dielectric charge storage elements that may be operated in multiple states to store more than one bit of data in individual charge storage regions. Selected portions of a multi-state memory cell array may also be operated in two states (binary) for various reasons, in a manner described in United States patents nos. 5,930,167 and 6,456,528.

Memory cells of a typical flash EEPROM array are divided into discrete blocks of cells that are erased together. That is, the block is the erase unit, a minimum number of cells that are simultaneously erasable. Each block typically stores one or more pages of data, the page being the minimum unit of programming and reading, although more than one page may be programmed or read in parallel in different sub-arrays or planes. Each page typically stores one or more sectors of data, the size of the sector being defined by the host system. An example sector includes 512 bytes of user data, following a standard established with magnetic disk drives, plus some number of bytes of overhead information about the user data and/or the block in which they are stored. Such memories are typically configured with 16, 32 or more pages within each block, and each page stores one or just a few host sectors of data.

In order to increase the degree of parallelism during programming user data into the memory array and read user data from it, the array is typically divided into sub-arrays, commonly referred to as planes, which contain their own data registers and other circuits to allow parallel operation such that sectors of data may be programmed to or read from each of several or all the planes simultaneously. An array on a single integrated circuit may be physically divided into planes, or each plane may be formed from a separate one or more integrated circuit chips. Examples of such a memory implementation are described in United States patents nos. 5,798,968 and 5,890,192.

To further efficiently manage the memory, physical blocks may be logically linked together to form virtual blocks or metablocks. That is, each metablock is defined to include one block from each plane. Use of the metablock is described in United States patent no. 6,763,424. The metablock is identified by a host logical block address as a destination for programming and reading data. Similarly, all blocks of a metablock are erased together. The controller in a memory system operated with such large blocks and/or metablocks performs a number of functions including the translation between logical block addresses (LBAs) received from a host, and physical block numbers (PBNs) within the memory cell array. Individual pages within the blocks are typically identified by offsets within the block address. Address translation often involves use of intermediate terms of a logical block number (LBN) and logical page.

Data stored in a metablock are often updated, the likelihood of updates as the data capacity of the metablock increases. Updated sectors of one logical metablock are normally written to another physical metablock. The unchanged sectors are usually also copied from the original to the new physical metablock, as part of the same programming operation, to consolidate the data. Alternatively, the unchanged data may remain in the original metablock until later consolidation with the updated data into a single metablock.

It is common to operate large block or metablock systems with some extra blocks maintained in an erased block pool. When one or more pages of data less than the capacity of a block are being updated, it is typical to write the updated pages to an erased block from the pool and then copy data of the unchanged pages from the original block to the erase pool block. Variations of this technique are described in aforementioned United States patent no. 6,763,424. Over time, as a result of host data files being re-written and updated, many blocks can end up with a relatively small number of its pages containing valid data and remaining pages containing data that is no longer current. In order to be able to efficiently use the data storage capacity of the array, logically related data pages of valid data are from time-to-time gathered together from fragments among multiple blocks and consolidated together into a fewer number of blocks. This process is commonly termed "garbage collection."

Individual flash EEPROM cells store an amount of charge in a charge storage element or unit that is representative of one or more bits of data. The charge level of a storage element controls the threshold voltage (commonly referenced as V_{T}) of its memory cell, which is used as a basis of reading the storage state of the cell. A threshold voltage window is commonly divided into a number of ranges, one for each of the two or more storage states of the memory cell. These ranges are separated by guardbands that include a nominal sensing level that allows determining the storage states of the individual cells. These storage levels do shift as a result of charge disturbing programming, reading or erasing operations performed in neighboring or other related memory cells, pages or blocks. For example, programming of one set of memory cells sharing a line or circuit with a second set of memory cells can disturb the charge levels of the second set. The end result of this parasitic disturb is that if no corrective action is taken on the part of the storage system controller, data in exposed areas not being operated on may be corrupted, and in an extreme case, beyond the corrective capabilities of any error correcting codes (ECCs) stored along with the data. Such data corruption would then result in loss of data to the user, thus rendering the storage system unreliable. The extent and nature of such disturbs in a particular memory cell array depends upon its specific architecture, structure and operation.

Therefore, it is beneficial to restore shifting charge levels back to the centers of their state ranges from time-to-time, before disturbing operations cause them to shift completely out of their defined ranges, in which case erroneous data are then read. Such a process, termed data refresh or scrub, is described in United States patents nos. 5,532,962, 5,909,449 and 7,012,835. As a further aspect of this, in memory systems that use error correction codes (ECCs), some number of erroneous data bits read from the memory may be corrected by use of the ECC and the corrected data is then re-written to a previously erased portion of the memory. Re-writing the data causes each of the written memory cell threshold levels to be within its designated state range since data programming usually involves alternately adjusting the stored charge and read-verifying the resulting memory cell threshold level until it reaches the desired range that represents the data being stored in the cell.

US 2005/0073884 discloses including a comprehensive scrub operation in a flash memory system to compensate for disturbs of storage levels in one group of memory cells that are caused by programming, reading or erasing operations performed on another group of memory cells on the same integrated circuit chip.

### SUMMARY OF INVENTION

The invention is defined by independent claims 1 and 9. According to a first aspect of the invention there is provided a method of operating a reprogrammable non-volatile memory system having an array of memory cells organized into NAND strings and a system controller connected thereto. The memory cells individually include a transistor having a source and drain, a charge storage element and a control gate. Each NAND string has a source end and a drain end and is formed by a series of charge storage transistors daisy-chained by the drain of one cell to the source of the adjacent charge storage transistor and is switchable to the source end by a source select transistor and switchable to the drain end by a drain select transistor. The method comprises, in the memory system, identifying the memory cells of the NAND strings to be in either a first group or a second group, recognizing when, in response to a command, data are read from memory cells of the first group but not at least some of the second group, in response to such a recognition, scrub reading data from at least some of the unread memory cells of the second group, thereafter measuring a number of errors in the data read from memory cells of the second group, thereafter determining from the number of measured data errors whether a refresh of the scrub read data is necessary, and if so, refreshing the data of memory cells in both of the first and second groups. The first and second groups are predefined such that memory cells of the second group are adjacent to either the source select transistor or the drain select transistor and the memory cells of the first group are the complement of the second group.

According to a second aspect of the invention there is provided a reprogrammable non-volatile memory system comprising a plurality of charge storage memory cells connected in a plurality of strings that individually contain a plurality of series connected memory cells, the strings being individually connectable at first and second ends thereof to respective first and second voltage sources and having word lines extending in a direction across the plurality of strings to individually define pages of memory cells. The memory system further comprises a controller connected with the charge storage memory cells and that operates to identify the memory cells of the strings to be in either a first group or a second group, recognize when, in response to a command, data are read from memory cells of the first group but not at least some of the second group, and, in response to such a recognition, scrub read data from at least some of the unread memory cells of the second group. The controller is further configured to, thereafter measure a number of errors in the data read from memory cells of the second group, thereafter determine from the number of measured data errors whether a refresh of the scrub read data is necessary, and if so, refresh the data of memory cells in both of the first and second groups. The first and second groups are predefined in the memory system such that the memory cells of the second group are adjacent to either the source select transistor or the drain select transistor and the memory cells of the first group are the complement of the second group.

The techniques described herein are principally directed to a situation where fewer than all the memory cells of a group of cells are read in response to a command, either from outside or from inside the memory system, and performing this read has a potential of disturbing the data stored in the group because of the physical structure of the memory system. The data stored in memory cells of the group that have not been read are primarily subject to such disturbs but data stored in memory cells that are read early in response to the command may in some cases be disturbed by later data reads of other memory cells.

The group of memory cells is typically but not necessarily a block of a large number of memory cells that are concurrently erasable prior to writing data into any memory cells of the group. The block is typically but not necessarily divided into a plurality of pages of memory cells, a page being the minimum unit for programming and reading data. One or more sectors of data are typically stored in each memory page. An ECC calculated from the data of a sector is usually stored along with the data of that sector. Commanded data reads normally include a check of the quality of the data read by use of the stored ECC. But when less than all the pages of a block are read, the effect of resulting disturbs on remaining pages not read is unknown. Also, the quality of a page of data read early in executing the command may be disturbed by reading subsequent pages, so an ECC check on the data read early may not provide an accurate indication of the quality of that data after the commanded partial block read is completed. Therefore, subsequent scrub reads of such data are often desirable.

In response to data being read from less than all of a group of memory cells by a host or otherwise, such as fewer than all the pages of a block, a scrub read is performed on a small proportion of the memory cells in the block, such as one or a small number of sectors, and the quality of the scrub read data is checked by use of the ECCs stored with the sectors of data. The scrub read most commonly, but not always, reads data stored in one or more pages that were not read in response to the command. If there are an excessive number of errors in the scrub read data, then the entire block is refreshed. A refresh operation involves reading all the data from the block, correcting the errors in the data by use of the ECCs, and then rewriting the corrected data into another block that has been erased. This process is desirably performed often enough to avoid the stored data being disturbed to the extent that they are no longer correctable by use of the ECCs, but not so often that performance of the memory system is excessively degraded. By limiting the scrub read to a small amount of the storage capacity of a block, such as just one or a few sectors or one or two pages, the overhead added to the memory operation by the scrub process is minimized. The scrub read and any resulting refresh are preferably performed in the background, when the memory system is not otherwise responding to commands to read or write data therein.

The scrub read preferably reads data stored in a page or pages of the block that are more vulnerable to having their data disturbed by the particular partial block command read than other pages of the block. It is preferred to identify a single most vulnerable sector or page, whenever that is possible, and then scrub read the data from it. Either way, a worse case picture of the quality of the data in the block is obtained with only a small amount of data needed to be scrub read. The impact on the performance of the memory system by such scrub reads is therefore minimized.

Objective criteria may be established to identify the portion of the group or block of memory cells, such as a page, that is more vulnerable to being disturbed by the command read than other portions of the group. At least some of the criteria are dependent upon the structure of the memory array. For example, in a NAND array, it is recognized that the pages formed by word lines at either end of the strings of series connected memory cells are more susceptible to disturbs from programming in other pages of the block than are the remaining pages in between. This is because the memory cells at the ends of the strings behave differently than those located away from the ends. If data in one or both of these pages has not been read in response to the command, it is likely that the data in the unread one of these pages have been disturbed to an extent that is greater than in other unread pages. A scrub read is then performed on the unread one or both of these more vulnerable pages.

Another of the criteria for selecting the more vulnerable page(s) may be established to be dependent upon which pages of the block have been read in response to the command and in what order. For instance, in the above example, even if one or both of the extreme pages of the block has been read in response to the command, one of these pages is desirably scrub read if it was read early in the execution of the command and therefore subject to thereafter being disturbed by the subsequent reading of other pages of the block. In such a case, the ECC check performed as part of the normal command read may no longer represent the quality of the data in that page because of potential disturbs that could have resulted from reading subsequent pages. If one or both of these extreme pages are read in response to the command at or toward the end of the commanded data read process, however, the ECC bit error checking that occurs as part of a normal data read provides information of the quality of the data in those page(s) so that another scrub read of the same page(s) need not take place.

A further possible one of the criteria for identifying a more vulnerable page is to identify a page that has not been read in response to the command but which is physically located adjacent a page that was so read. Disturbs are more likely to occur on this page than other pages in the block, with the possible exception of the two pages at the extreme ends of NAND memory strings. This will depend upon the specific structure of the memory cell array.

Yet another of the established criteria can be the relative patterns of data stored in the pages of the block. For example, in the NAND memory array, disturbs of the charge levels of memory cells in states near or at their lowest stored charge levels is more likely than those with charge levels near or at their highest stored charge levels. This is because potentially disturbing voltages experienced by a memory cell with the lowest charge level are higher than those of a memory cell with the highest charge level. Therefore, a page with data represented by predominately low charge levels stored in its memory cells will be more vulnerable to disturbs than one with data represented primarily by higher stored charge levels. This is therefore another factor that may be used to select a more vulnerable page as a candidate for a scrub read.

There may be situations, as a result of applying the defined criteria for identifying the more or most vulnerable page in a particular partially read block, where no such page is identified. In this case, no scrub read takes place on that particular block. This means that it is unlikely that the quality of the data in any pages of the block is significantly less than that measured by use of the ECCs of the data read in response to the command. For example, as described above, if at least one of the extreme pages of a NAND string array is read near the end of the commanded read process, the ECCs obtained from this read provides a current indication of the quality of the data stored there. If the number of bit errors is zero or below some defined threshold, then it is known that the quality of the data in the page is acceptable, which may be taken to be an indication of the worst quality of data stored in the block. A scrub read on some other page is then unnecessary. On the other hand, if the number of bit errors is at or above the defined threshold, a refresh of all the data in the block is indicated, also without having to do a separate scrub read.

Additional aspects, advantages and features of the present invention are included in the following description of exemplary examples thereof, which description should be taken in conjunction with the accompanying drawings.

All patents, patent applications, articles, books, specifications, other publications, documents and things referenced herein are hereby incorporated herein by this reference in their entirety for all purposes. To the extent of any inconsistency or conflict in the definition or use of a term between any of the incorporated publications, documents or things and the text of the present document, the definition or use of the term in the present document shall prevail.

### BRIEF DESCRIPTION OF THE DRAWINGS

Figures 1A and 1B are block diagrams of a non-volatile memory and a host system, respectively, that operate together;
Figure 2 illustrates a first example organization of the memory array of Figure 1A;
Figure 3 shows an example host data sector with overhead data as stored in the memory array of Figure 1A;
Figure 4 illustrates a second example organization of the memory array of Figure 1A;
Figure 5 illustrates a third example organization of the memory array of Figure 1A;
Figure 6 shows an extension of the third example organization of the memory array of Figure 1A;
Figure 7 is a circuit diagram of a group of memory cells of the array of Figure 1A with one particular configuration;
Figure 8 shows curves of example distributions of voltage threshold levels of a group of programmed memory cells;
Figures 9A, 9B and 9C give three examples of different memory operational patterns within a single block that illustrate a possible need to refresh data stored in the block;
Figure 10 is a flowchart that illustrates a first example of major steps in a memory scrub and refresh operation; and
Figure 11 is a flowchart that illustrates a second example of major steps in a memory scrub and refresh operation.

### DESCRIPTION OF EXEMPLARY EMBODIMENTS

### Memory Architectures and Their Operation

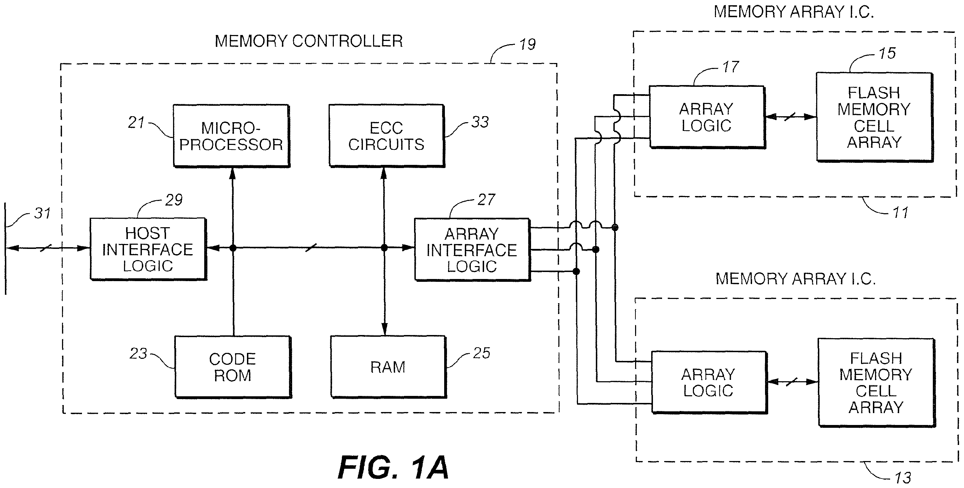

Referring initially to Figure 1A, a flash memory includes a memory cell array and a controller. In the example shown, two integrated circuit devices (chips) 11 and 13 include an array 15 of memory cells and various logic circuits 17. The logic circuits 17 interface with a controller 19 on a separate chip through data, command and status circuits, and also provide addressing, data transfer and sensing, and other support to the array 13. A number of memory array chips can be from one to many, depending upon the storage capacity provided. The controller and part or the entire array can alternatively be combined onto a single integrated circuit chip but this is currently not an economical alternative.

A typical controller 19 includes a microprocessor 21, a read-only-memory (ROM) 23 primarily to store firmware and a buffer memory (RAM) 25 primarily for the temporary storage of user data either being written to or read from the memory chips 11 and 13. Circuits 27 interface with the memory array chip(s) and circuits 29 interface with a host though connections 31. The integrity of data is in this example determined by calculating an ECC with circuits 33 dedicated to calculating the code. As user data is being transferred from the host to the flash memory array for storage, the circuit calculates an ECC from the data and the code is stored in the memory. When that user data are later read from the memory, they are again passed through the circuit 33 which calculates the ECC by the same algorithm and compares that code with the one calculated and stored with the data. If they compare, the integrity of the data is confirmed. If they differ, depending upon the specific ECC algorithm utilized, those bits in error, up to a number supported by the algorithm, can be identified and corrected. Typically, an ECC algorithm is used that can correct up to 8 bits in a 512 byte sector.

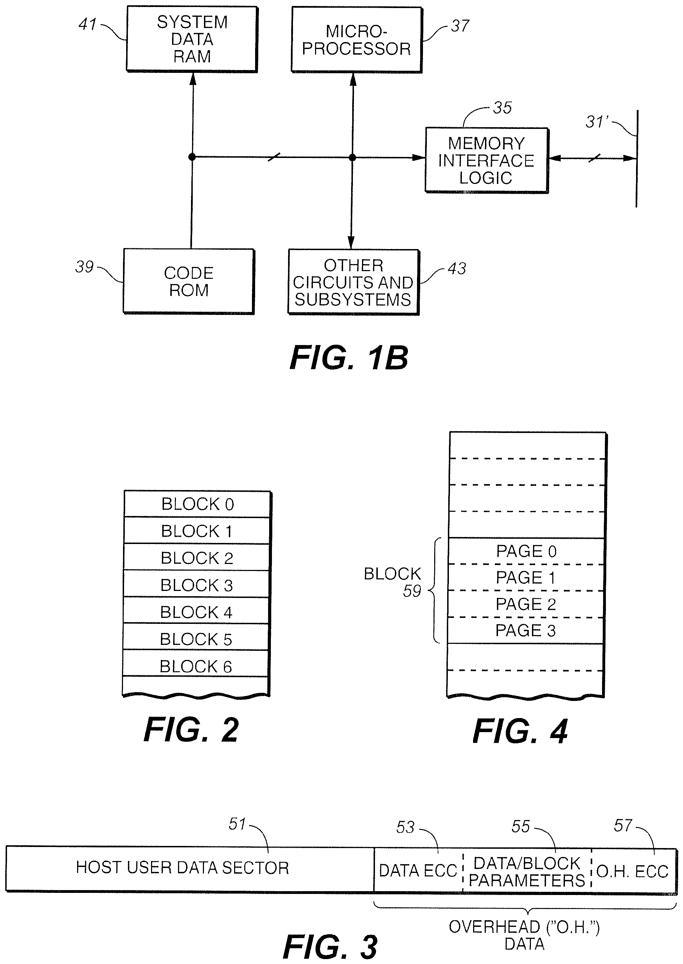

The connections 31memory of Figure 1A mate with connections 31' of a host system, an example of which is given in Figure 1B. Data transfers between the host and the memory of Figure 1A through interface circuits 35. A typical host also includes a microprocessor 37, a ROM 39 for storing firmware code and RAM 41. Other circuits and subsystems 43 often include a high capacity magnetic data storage disk drive, interface circuits for a keyboard, a monitor and the like, depending upon the particular host system. Some examples of such hosts include desktop computers, laptop computers, handheld computers, palmtop computers, personal digital assistants (PDAs), MP3 and other audio players, digital cameras, video cameras, electronic game machines, wireless and wired telephony devices, answering machines, voice recorders, network routers and others.

The memory of Figure 1A may be implemented as a small enclosed card containing the controller and all its memory array circuit devices in a form that is removably connectable with the host of Figure 1B. That is, mating connections 31 and 31' allow a card to be disconnected and moved to another host, or replaced by connecting another card to the host. Alternatively, the memory array devices may be enclosed in a separate card that is electrically and mechanically connectable with a card containing the controller and connections 31. As a further alternative, the memory of Figure 1A may be embedded within the host of Figure 1B, wherein the connections 31 and 31' are permanently made. In this case, the memory is usually contained within an enclosure of the host along with other components.

Certain terms used in this description can benefit from some explanation. A "sector" refers to independently addressable units of data accessed during host read and write operations. One sector of data is typically 512 bytes in size.

The "memory system" as used herein is a system consisting of one or more non-volatile memory devices and the hardware and/or software required to store and retrieve data to and from the memory. Varying portions of the overall memory system may be implemented functionally either on a subsystem completely dedicated to data storage, or on the host system itself. The memory system may be embedded in a host system or may be removable, such as in the form of a very small card. Portions of a removable memory system may themselves be removable, as for example if the storage media portion is removable from the controller portion. Any portion of a host system dedicated specifically to data storage in a memory system is also considered a part of the memory system. Such host functionality may include specialized software libraries, drivers, or applications in addition to any hardware residing on the host system.

For the purposes used herein, a "host system" is a system that generally has a functionality other than data storage, but which also either removably connects to the memory system, or has the memory system embedded in it. There can be host systems whose sole purpose is data storage.

The various techniques for refreshing and scrubbing data stored in flash memory described herein may be implemented in systems having various specific configurations, examples of which are given in Figures 2 - 6. Figure 2 illustrates a portion of a memory array wherein memory cells are grouped into blocks, the cells in each block being erasable together as parts of a single erase operation, usually simultaneously. The physical block is the minimum unit of erase.

The size of the individual memory cell blocks of Figure 2 can vary but one commercially practiced form includes a single sector of data in an individual block. The contents of such a data sector is illustrated in Figure 3. User data 51 are typically 512 bytes of data. In addition to the user data 51 are overhead data that includes an ECC 53 calculated from the user data, parameters 55 relating to the sector data and/or the block in which the sector is programmed and an ECC 57 calculated from the parameters 55 and any other overhead data that might be included. The parameters 55 may include a quantity related to the number of program/erase cycles experienced by the block ("hot counts"), this quantity being updated after each cycle or a preset number of cycles. One use of this experience quantity is to regularly re-map logical block addresses to different physical block addresses in order to even the usage (wear leveling) of all the blocks. Another use of the experience quantity is to change voltages and other parameters of programming, reading and/or erasing as a function of the number of cycles experienced by different sectors.

The parameters 55 may also include an indication of the bit values assigned to each of the storage states of the memory cells, commonly referred to as their "rotation". That is, logical states of the data are mapped to different physical storage states. This also has a beneficial effect in wear leveling. One or more flags may also be included in the parameters 55 that indicate status or states. Indications of voltage levels to be used for programming and/or erasing the block can also be stored within the parameters 55, these voltages being updated as the number of cycles experienced by the block and other factors change. Other examples of the overhead parameters 55 include an identification of any defective cells within the block, the logical address of the data block that is mapped into this physical block and the address of any substitute physical block in case the primary block is defective. The particular combination of parameters 55 that are used in any memory system will vary in accordance with the design. Also, some or all of the overhead data can be stored in physical blocks dedicated to such a function, rather than in the block containing the user data or to which the overhead data relates.

Different from the single data sector block of Figure 2 is a multi-sector physical block of Figure 4. An example block 59, still the minimum unit of erase, contains four pages 0 - 3, each of which is the minimum unit of programming. One or more host sectors of data are stored in each page, usually along with overhead data including at least the ECC calculated from the sector's data and may be in the form of the data sector of Figure 3. When data of less than all the pages are updated, the updated data are typically stored in a page of an erased block from an erased block pool and data in the remaining unchanged pages are copied from the original block into the new block. The original block is then erased. Variations of this large block management technique include writing the updated data into a page of another block without moving data from the original block or erasing it. This results in multiple pages having the same logical address. The most recent page of data is identified by some convenient technique such as the time of programming that is recorded as a field in sector or page overhead data.

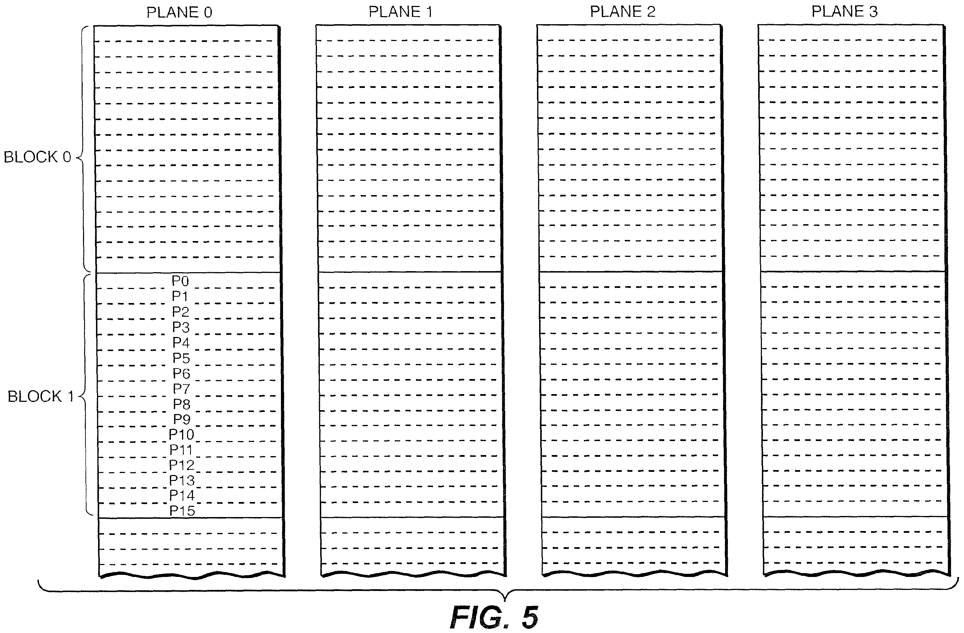

A further multi-sector physical block arrangement is illustrated in Figure 5. Here, the total memory cell array is physically divided into two or more planes, four planes 0 - 3 being illustrated. Each plane is a sub-array of memory cells that has its own data registers, sense amplifiers, addressing decoders and the like in order to be able to operate largely independently of the other planes. All the planes may be provided on a single integrated circuit device or on multiple devices, an example being to form each plane from one or more distinct integrated circuit devices. Each block in the example system of Figure 5 contains 16 pages P0 - P15, each page having a capacity of one, two or more host data sectors and some overhead data.

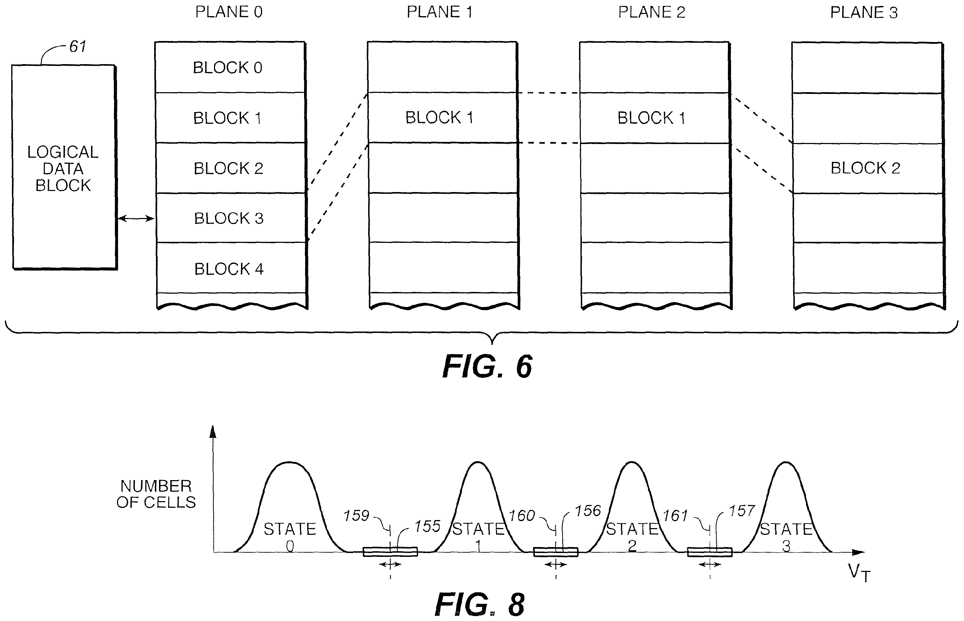

Yet another memory cell arrangement is illustrated in Figure 6. Each physical plane contains a large number of blocks of cells. In order to increase the degree of parallelism of operation, blocks within different planes are logically linked to form metablocks. One such metablock is illustrated in Figure 6 as being formed of block 3 of plane 0, block 1 of plane 1, block 1 of plane 2 and block 2 of plane 3. Each metablock is logically addressable and the memory controller assigns and keeps track of the blocks that form the individual metablocks. The host system preferably interfaces with the memory system in units of data equal to the capacity of the individual metablocks. Such a logical data block 61 of Figure 6, for example, is identified by a logical block addresses (LBAs) that are mapped by the controller into the physical block numbers (PBNs) of the blocks that make up the metablock. All blocks of the metablock are erased together, and individual pages from each physical block within a logical metablock are preferably programmed and read simultaneously.

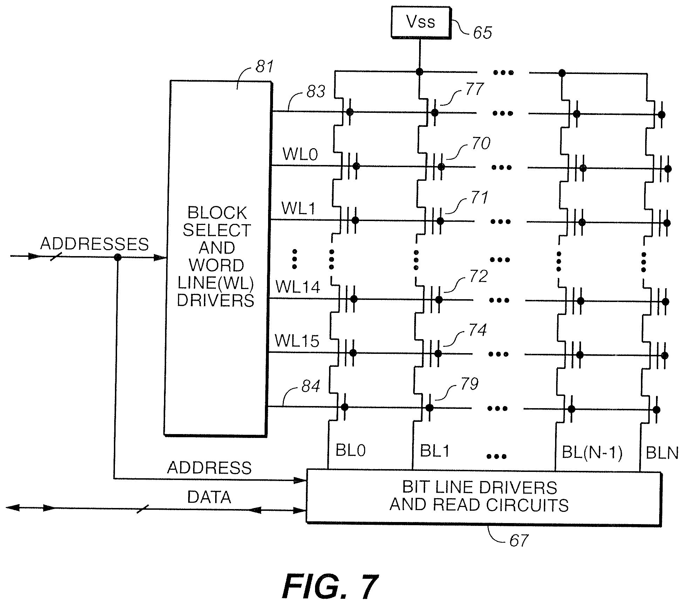

There are many different memory array architectures, configurations and specific cell structures that may be employed to implement the memories described above with respect to Figures 2 - 6. One block of a memory array of the NAND type is shown in Figure 7. A large number of column oriented strings of series connected memory cells are connected between a common source 65 of a voltage V_{SS} and one of bit lines BL0 - BLN that are in turn connected with circuits 67 containing address decoders, drivers, read sense amplifiers and the like. Specifically, one such string contains charge storage transistors 70, 71 .. 72 and 74 connected in series between select transistors 77 and 79 at opposite ends of the string. In this example, each string contains 16 storage transistors but other numbers are possible. Word lines WL0 - WL15 individually extend across one storage transistor of each string and are connected to circuits 81 that contain address decoders and voltage source drivers of the word lines. Voltages on lines 83 and 84 control connection of all the strings in the block together to either the voltage source 65 and/or the bit lines BL0 - BLN through their select transistors. Data and addresses come from the memory controller.

Each row of charge storage transistors (memory cells) of the block forms a page that is programmed and read together. An appropriate voltage is applied to the word line (WL) of such a page for programming or reading its data while voltages applied to the remaining word lines are selected to render their respective storage transistors conductive. In the course of programming or reading one row (page) of storage transistors, previously stored charge levels on unselected rows can be disturbed because of voltages applied across all the strings and to their word lines.

An example of operating the individual storage elements in a flash memory array in four states is illustrated in Figure 8. A distribution of a number of storage elements within a unit of memory cells, such as a sector or page, within each of four threshold voltages (V_{T}) level ranges is shown. Threshold voltage guard bands 155, 156 and 157 are maintained between the storage state threshold level ranges with an absence of data from any cells therein. This is the desired programmed condition that exists immediately after programming and verifying the states of a unit of cells. But as other units are then programmed, read and/or erased, this data can be disturbed. Disturbs are exhibited by the threshold levels shifting to one side or the other into the adjacent guard bands. This can occur for a small proportion of the cells within each state distribution or the entire distribution can shift or spread into adjacent guard bands, depending upon the nature of the disturbs.

For a normal read, breakpoint levels 159, 160 and 161 in about the middle of the respective guard bands 155, 156 and 157 are used. That is, the threshold levels of the cells being read are compared with these breakpoint levels to determine their storage states. Errors occur when the threshold levels of cells within one state shift through a guard band across a breakpoint level. For example, when the threshold levels of cells in state 1 shift lower until they are below the breakpoint level 159, those cells are then read to be in state 0. Similarly, if the threshold levels of cells in state 1 shift higher until above the breakpoint level 160, a normal read will say that those cells are in state 2. Such read data errors are then identified by the ECC process.

But when there are too many such errors for the particular ECC algorithm being used to correct, a second read with different breakpoint levels between states may be made. The breakpoint levels 159, 160 and 161 are shifted within their respective guard bands in a direction of the expected shift of storage threshold levels from the disturbs, so that the shifted levels are now on the same side of the guard band as they were before being disturbed. If this still does not read data that can be corrected by the ECC, the scrub operation will usually be determined to have failed and the page or memory block in which the uncorrectable errors exist is marked as bad. The data that cannot be read is then lost. Since these data were verified as part of the original programming to initially be in their correct threshold level range, this effect of an accumulation of disturbing operations over time shows the desirability of scrubbing frequently enough to avoid such an adverse consequence.

It may also be desirable to further check and adjust the storage levels of cells from which even valid data are read. This involves re-reading the data with different break point levels than used in the initial read, in order to identify any cells where the stored charge has moved into a guard band between the levels defined for the various states (see Figure 8), even though those levels have not crossed a breakpoint level to cause a normal read data error. The breakpoint levels used during this read, for example, are shifted to edges of the guard bands 155, 156 and 157 of Figure 8. If it is then determined by use of the ECC that errors in the read data exist, the erroneous bits of data indicate the shifting of charge levels to cause memory cell threshold levels to move into the guard bands. So it may be desirable to correct and rewrite these data, so that the stored charge levels will be shifted out of the guard bands to within their intended state distributions of Figure 8.

### Data Scrub and Refresh, Generally

A particular scrub operation included in a flash memory system compensates for disturbs of storage levels in one group of memory cells that are caused by programming, reading or erasing operations performed on another group of memory cells on the same integrated circuit chip. The potential for such data disturbs increases as the memory cell arrays are shrunk in size. There is a tendency, in order to save space, for various signal lines to be shared among groups of memory cells such that one group experiences potentially repetitive exposure to voltages and/or currents during programming, reading or erasing the memory cells of another group. By scrubbing the data stored in all groups of memory cells in an organized and continuous manner, corruption of stored data over time is significantly reduced. Also, the storage of an increased number of bits per memory cell with an increased number of smaller voltage threshold state ranges is made practical when the disturbed charge levels are corrected by methodically restoring them to their intended levels.

A scrub operation entails reading data in areas that have received exposure to potentially disturbing signals, and performing some corrective action if this data is determined to have been disturbed. Disturbs may be detected, for example, by checking the integrity of the data, such as by reading the data and obtaining the results of an ECC check of the data. Corrective action may entail rewriting the data in the same location, or in a different location, and it can involve a higher-level defect or data management operation.

Scrub operations are preferably performed in the background, when the memory system is not reading or writing data. The memory system may look to the host to indicate when the host will not be asking the memory to store or retrieve data, during which time a scrub operation may be carried out.

Even if one or more data errors are detected in a particular scrub read, it might be determined not to take corrective action if the error(s) can be corrected by ECC upon reading the data, in order to maintain system performance. When user data and overhead data of the individual sectors have their own ECC, data errors in the overhead data are less likely to be allowed to go uncorrected than errors in the user data.

In memory systems utilizing large blocks or metablocks of memory cells that individually store a large number of host data sectors, a sector(s) of data of a first physical block that is corrected during a scrub operation may be re-written into a second block into which remaining data sectors of the first block are copied, consistent with the erase pooling method of memory management described above. Alternately, a block or metablock may be dedicated to the temporary storage of scrub corrected data sectors until other data sectors from the same blocks or metablocks as the corrected sector(s) need to be moved for some other reason, such as for garbage collection, at which time the scrub corrected data sectors may be recombined with other data sectors of the same block or metablock. This improves system performance.

Once it is determined that corrective action needs to be taken with certain specified data, that action may be deferred if taking the corrective action at that time may adversely affect system performance, and if the data can be read without the corrective action, if necessary, before the corrective action later takes place. All corrected data, addresses and various parameters as determined at the time of deferral are temporarily stored and later retrieved when a deferred corrective action is executed. In systems organized in large blocks or metablocks of memory cells, corrective scrub actions may be deferred until a given amount of data from a given block or metablock are scheduled for corrective action, in which case all the deferred data sectors of the given block or metablock are corrected at the same time. This can reduce the amount of data copying and re-writing that occurs when the data sectors of the given block or metablock are consolidated together again.

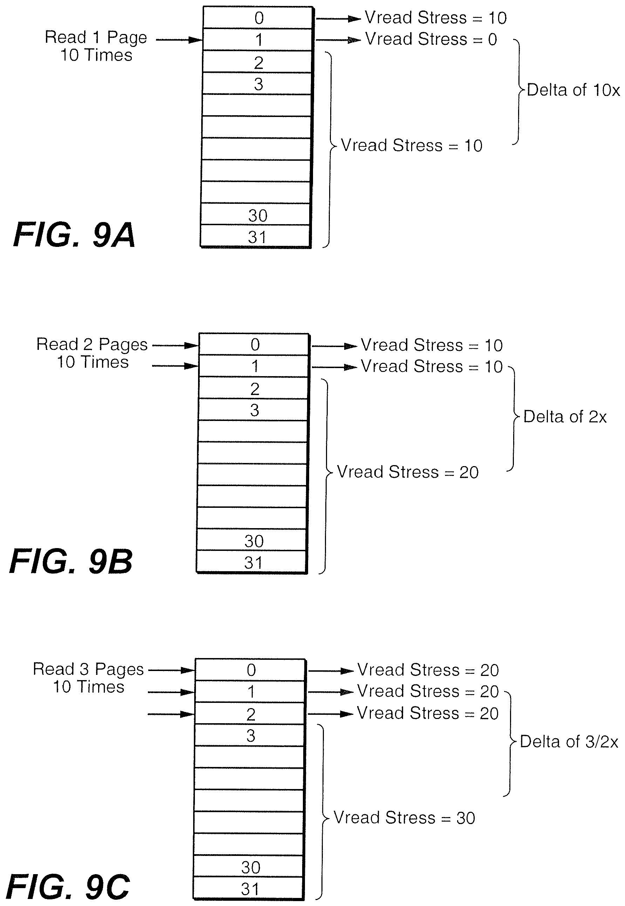

Figures 9A, 9B and 9C illustrate three examples of stresses to which individual pages of a block can be subjected when less than all pages of the block are read, particularly when only one or a very few pages are read multiple times while remaining pages of the block are not read. In these examples, the block contains thirty-two pages 0-31.

In the first example of Figure 9A, page 1 has been read ten times during a period when none of the other pages of the block are read. The worst case scenario is when the system repeatedly performs a single page read, the situation illustrated by Figure 9A. Stored charge levels in memory cells of the other pages in the same block are subjected to potentially disturbing voltages every time the single page is read. Shifts in the charge levels in these other pages, and thus shifts in the memory cell threshold levels, go undetected. Upon each of the multiple reads of the data from page 1 of Figure 9A, the validity of that data is checked by use of its stored ECC. Any need to refresh the data stored in page 1 is thus discovered as a normal part of reading its data. But no such check is made on the data of the other pages 0 and 2-31. The charge levels in the memory cells of pages 0 and 2-31 may be changed in value (disturbed) by voltages applied to them as a consequence of reading page 1. Causes of such disturbs include voltages on bit lines that run through all the pages, voltages applied to the word lines of the non-selected pages 0 and 2-31 to render their memory cells conductive, and the like.

Each time page 1 of the Figure 9A example is read, these voltages create a stress on the memory cells of the remaining pages in the block. This can be considered, for discussion purposes, to be a read stress of 1. Therefore, as indicated in Figure 9A, ten reads of page 1 causes each of the other pages 0 and 2-31 of the block to be subjected to a stress of 10 during this period. The effect of this stress on the individual pages 0 and 2-31 depends upon the vulnerability of the pages to disturbs. As described elsewhere herein, the vulnerability of a particular one of the pages 0 and 2-31 depends upon many factors. One factor is its location within the block. End pages 0 and 31 are most vulnerable because of the higher voltages placed across them. This vulnerability is described in pending United States patent applications nos. 11/618,482 and 11/618,498, both filed December 29, 2006. Also, pages 0 and 2 have a higher degree of vulnerability than pages 3-31 because they are adjacent the page 1 that is being read multiple times. Another vulnerability factor is the pattern of data stored in the individual pages that are not read. Because the pages 0 and 2-31 may have different levels of vulnerability, the effect on them individually from exposure to the same level of read stress may not be the same.

In the example of Figure 9B, data stored in pages 0 and 1 are read ten times each, during a period when the data in pages 2-31 are not read at all. This creates a stress level of 20 on each of the unread pages 2-31. Each of the read pages 0 and 1 have a stress level of 10, once for each time data of the other of the pages 0 and 1 are read.

Similarly, in the example of Figure 9C, data are read from each of three pages 0-3 ten times while the remaining pages 3-31 of the block are not read at all. The read stress on each of the pages 3-31 is 30, once for each of the total number of thirty reads on pages 0-2. Each of the pages 0-2 is subjected to 20 units of stress, one for each of the reads of the other two pages.

### Specific Read Scrub Process Examples

The purpose of Figures 9A-9C is to demonstrate the stress levels to which pages of a partially but repeatedly read block are subjected. These stress levels could be monitored and, when combined with the different vulnerabilities of the pages in the block, used to identify the page whose data are most likely to be disturbed after such multiple reads. This is the page of the block that is most likely to contain data errors. That page would then be scrub read in order to determine the quality of the data stored in it. If the quality of the data in such a page is good, then it follows that the quality of the data stored in the other pages of the block is even better. Only one page of the block therefore needs to be scrub read after some number of reads of less than all its pages. This is an efficient scrub process.

But that process requires keeping track of the number of reads of less than all the pages of each block in the system, and then making a determination of when the stress level of a page within an individual block, combined with its possibly unique level of vulnerability to disturbs, justifies scrub reading the data in that page. It is preferable in the specific scrub process examples described herein to avoid having to keep track of the number of reads of individual pages. Indeed, it is preferable that the scrub process not require keeping track of any historical operation data, thereby neither requiring the use of memory system resources for that purpose nor degrading the performance of the memory system.

Therefore, the scrub read of data in a very small proportion of the pages of a block, preferably a single page but typically no more than two pages, is considered after every partial read of the block and executed after most of them. That is, when memory system executes a command from the host or the memory system controller to read pages of one block, it is determined upon the host or controller commanding that data be read from some other block, or that some other operation be performed, that reading data from the first block has been completed. It is then determined whether fewer than all the pages of the block were read. If so, with some few exceptions, the data of one page is typically scrub read from that block.

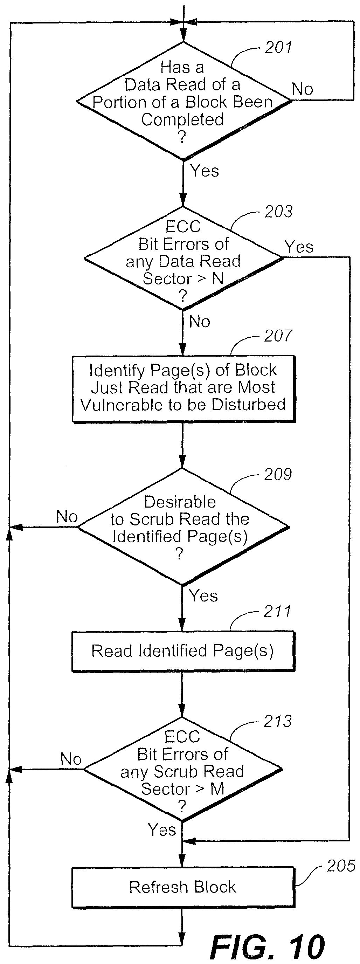

Referring to Figure 10, a specific example scrub algorithm is illustrated in a flowchart form. In a first step 201, it is determined whether there has been a partial block read, in the manner described in the immediately preceding paragraph. As soon as reading data from another block is commanded, for example, it is known that reading of the first block has ended. If less than all the pages of that first block were read, it is known that a partial data read of that block has been completed.

A next step 203 considers whether any bit errors of the data read from the pages exceeds a predetermined threshold. A number of acceptable bit errors for a unit of read data is set, in this example a number N. This is a number of bit errors of a unit of data upon which ECC is calculated, a sector of data in this example, which can be tolerated. The number N can be 0, thus not tolerating any data errors but then requiring frequent data refresh operations. Alternately, if N is set to the maximum number of bits that the ECC algorithm being used can correct, such as 8 bits, only the existence of uncorrectable data will trigger refresh of the block. In the later case, the refresh operation will have to read the sector or other unit of data having more than the number of correctable bit errors with relaxed read thresholds, as discussed above. Therefore, some number N between these two extremes is selected for the threshold. For example, if the ECC algorithm can correct up to 8 bits, N may be selected to be one-half of that, or even higher at 5 or 6 bits. If the number of bit errors in any sector or other unit of command read data exceeds this threshold, the process proceeds immediately to a step 205, wherein data in the entire block is refreshed.

If it is determined in the step 203 that the number of any bit errors in the commanded data read is below the threshold, a single page, or, alternatively, a very small proportion of the number of pages of the block, are identified for a scrub read, in a step 207. This is the page(s) of the block that is determined to be most vulnerable to having its data disturbed as the result of the completed partial block command read. The various criteria that may be employed in the step 207 to identify the most vulnerable block(s) will now be described.

One criterion is the physical position of the pages within the block. In a NAND array, the first and last pages, such as pages 0 and 31 of Figures 9A-9C, are more likely than the pages in between, such as pages 1-30, to have their stored charge levels altered when other pages of the block are read. As discussed above, this is because, when reading data from a page of the block, higher voltages are applied across these extreme pages than across those pages in between. Therefore, when determining the most vulnerable page in the block, these two pages are considered.

Another criterion is the identity of the page(s) subjected to the command read, and the order in which they were read. For example, if data are read from one the first and last physical pages as the last page of the command read, the normal quality check of the read data by use of the ECC will be current and a scrub read of that page is unnecessary. However, if data are command read from one of these extreme pages, followed by a command read of other pages within the block, reading these other pages can disturb the data stored in the one extreme page. Its data quality indication determined by use of the ECC as part of the command read is no longer current. The earlier read extreme page of the block can therefore be vulnerable to being disturbed from the subsequent reading of the other page(s) of the block. This also points out that noting which page(s) of a subject block has been command read and which have not been so read is another criterion used to identify the most vulnerable page(s). The number of pages command read after reading a particular page may also be considered in determining whether the particular page is the most vulnerable of the pages in the block.

The number of bit errors in the data read from various pages in response to a command, as determined by the ECC in the ordinary course of reading the data, can also be a criterion that is used in some circumstances to identify the most vulnerable page(s). For example, the number of bit errors in data that have been command read from one of the extreme pages 0 or 31 of a block may be used to determine whether that page is a candidate for the most vulnerable page. This is the case when other pages are command read after the extreme page, and thus subject the data in the extreme page to the possibility of being disturbed. If the number of bit errors of the data command read from the extreme page is zero or low, then it can be concluded that the subsequent command reads of other pages in the block is unlikely to have disturbed the data in the extreme page to an extent that corrective action may be necessary. On the other hand, if the number of bit errors is relatively high, such as 4-6 with use of an ECC algorithm that can correct 8 bits, that extreme page may be a candidate for the most vulnerable page, depending upon the situation with other pages of the block.

Yet another criterion for identifying the most vulnerable page(s) of a block is the physical proximity of pages not read in response to the command and those that were read. For example, data stored in an unread page immediately adjacent a page that was command read are typically more likely to be disturbed than a page separated from a command read page by one or more unread pages.

A further criterion that may be included in making the determination of step 207 of Figure 10 is the pattern of data stored in the pages of the block. In NAND arrays, for example, disturbs of charge levels stored in memory cells at or near the lowest level that represents a storage state are more vulnerable to being disturbed than higher levels of charge being stored. So the number of charge storage elements or memory cells of a given page having the lowest charge level state stored therein versus the number that are storing higher charge levels, particularly the number storing the highest, is a criterion that may be used to determine the most vulnerable page(s) of the block.

The step 207 of Figure 10 may be carried out by considering only one of the criteria discussed above, such as whether a page is one of the extreme pages. Alternatively, all or some number less than all of these criteria may be used together by assigning relative levels of importance to each.

Once the most vulnerable page(s) of the block is identified, a next step 209 determines whether the identified page(s) should be scrub read. A scrub read will take place in most all cases, after a partial command read of a block. But there are circumstances where a scrub read need not take place. If the page identified to be the most vulnerable was read at or toward the end of the command read, for example, it will not be scrub read. This is because the quality of its data has already been determined in the step 203 to be good, and nothing has occurred that will is likely to caused that data to be disturbed. If the data is determined in the step 203 to be of low quality, of course, the steps 207 and 209 do not occur, since the block is then refreshed by the step 205.

A next step 211 is to scrub read the page(s) identified in the step 207 to have a high vulnerability to disturbs relative to other pages, or even identified to be the most vulnerable of all the pages in the block. The number of bit errors of the scrub read data are determined in the next step 213. That number is, in the embodiment of Figure 10, compared with a preset number M. This number M may be the same as the threshold number N used with command read data in the step 203, or different. The level of confidence that the most vulnerable page has been identified in the step 207 will typically determine whether M is set to be near the upper end of the number of bits that the ECC can correct, if the confidence level is high, or whether it is best more conservatively set to a lower number.

Regardless of the specific number M, if any one sector, or other unit of data upon which the ECC is based, within the scrub read page(s) has a number of bit errors in excess of M, the process proceeds to step 205 to refresh the entire block in which the scrub read page(s) is located. But if the number of bit errors determined by the ECC in the scrub read data is higher than M, the block in which the subject pages reside is refreshed, in the step 205. This typically includes reading all the pages of data in the block, correcting the read data by use of the ECC, and then rewriting the corrected data into an erased block of the system erased block pool. The first block is then erased and placed into the pool. If any of the read pages cannot be corrected by use of the ECC with normal read reference levels, as part of the refresh operation, these levels can be changed and the data reread with the different reference levels in order to reduce the number of bit errors. This data may then be corrected by the ECC, if necessary.

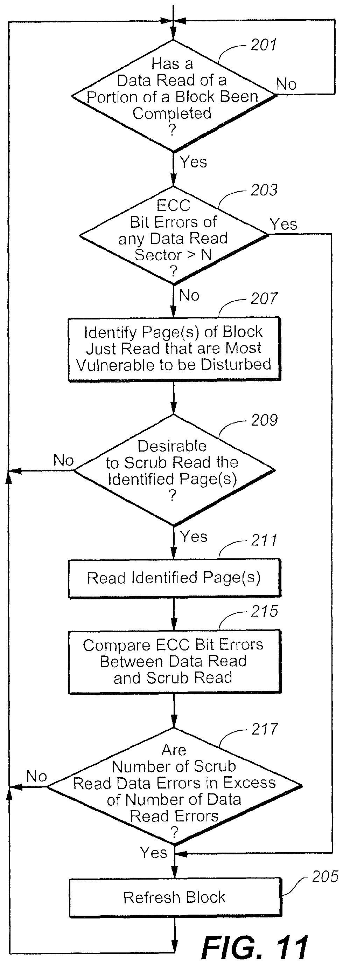

The flowchart of Figure 11 illustrates an alternative algorithm to that of Figure 10. But most of the steps are the same, so these are given the same reference numbers. What is different is the way in which it is determined from the number of bit errors in the scrub read data whether the block needs to be refreshed. The step 213 of the algorithm of Figure 10 is replaced in the flow chart of Figure 11 with steps 215 and 217. Instead of comparing the number of scrub read bit errors with a fixed threshold M, the method of Figure 11 compares the number of scrub read bit errors with the number of bit errors determined in the step 203 to exist in the data that was command read from the same block.

In the step 215, the number of scrub read data bit errors are compared with the number of command read data bit errors. In the next step 217, it is determined whether the number of scrub read errors is in excess of the number of command read errors. If so, the block in which both the command read and scrub read have taken place is refreshed, in the step 205. But if the number of scrub read errors is equal to or less than the number of command read errors, it is determined that no refresh of the block is necessary.

There are typically multiple bit error quantities that result from each of these data reads since multiple sectors or other units of data upon which the ECCs are calculated are typically read together. The comparison is therefore preferably made between the maximum number of bit errors resulting from each of the command and scrub reads.

As an alternative to such a comparison of magnitudes of bit errors, a ratio may be taken of the command read and scrub read bit error numbers, preferably the maximum number of errors determined from their ECCs to exist in each read. This ratio is then compared with a predefined number. If that number is set to one, refresh of the block will occur when a ratio of the number of scrub read bit errors to the number of command read bit errors is greater than one.

### Conclusion

Although the various aspects of the present invention have been described with respect to exemplary embodiments thereof, it will be understood that the present invention is entitled to protection within the full scope of the appended claims.

## Claims

1. A method of operating a reprogrammable non-volatile memory system having an array of memory cells organized into NAND strings and a system controller connected thereto, the memory cells individually including a transistor (70, 71, 72, 74) having a source and drain, a charge storage element and a control gate, each NAND string having a source end and a drain end and being formed by a series of charge storage transistors (70, 71, 72, 74) daisy-chained by the drain of one cell (70, 71, 72, 74) to the source of the adjacent charge storage transistor (70, 71, 72, 74) and switchable to the source end by a source select transistor (77) and switchable to the drain end by a drain select transistor (79), the method comprising, in the memory system:
identifying the memory cells (70, 71, 72, 74) of the NAND strings to be in either a first group (71, 72) or a second group (70, 74),
recognizing when, in response to a command, data are read from memory cells of the first group (71, 72) but not at least some of the second group (70, 74),
in response to such a recognition, scrub reading data from at least some of the unread memory cells of the second group (70, 74),
thereafter measuring a number of errors in the data read from memory cells of the second group (70, 74),
thereafter determining from the number of measured data errors whether a refresh of the scrub read data is necessary, and
if so, refreshing the data of memory cells in both of the first (71, 72) and second groups (70, 74)
**CHARACTERISED IN THAT**:
the first and second groups are predefined such that the memory cells of the second group (70, 74) are adjacent to either the source select transistor (77) or the drain select transistor (79) and the memory cells of the first group (71, 72) are the complement of the second group.

2. The method as in Claim 1, wherein said storing is by programming in parallel a page of memory cells (70, 71, 72, 74) with a common word line extending across a plurality of NAND strings.

3. The method as in Claim 1 or Claim 2, wherein the array is divided into blocks that individually include a plurality of NAND strings whose memory cells (70, 71, 72, 74) are concurrently erasable prior to programming data therein, and the first (71, 72) and second (70, 74) groups of memory cells are located in a given block of memory cells.

4. The method of any preceding Claim, wherein determining whether data in the block are to be refreshed includes comparing the number of bit errors of at least the scrub read data with a preset threshold.

5. The method of any preceding Claim, additionally comprising measuring a number of bit errors in the data command read from one or more pages of the given block, and wherein determining whether data in the block are to be refreshed includes comparing the number of bit errors in the scrub read data with the number of bit errors in the command read data.

6. The method of Claim 5, wherein comparing the data bit errors includes calculating a ratio of the number of bit errors in the scrub read data and the number of bit errors in the command data read, and thereafter comparing the ratio with a pre-defined threshold.

7. The method of any preceding Claim, wherein the command to read data from memory cells of the first group (71, 72) but not at least some of the second group (70, 74) is received from outside of the memory system.

8. The method of any of Claims 1 to 6, wherein the command to read data from memory cells of the first group (71, 72) but not at least some of the second group (70, 74) is generated within the memory system.

9. A reprogrammable non-volatile memory system, comprising:
a plurality of charge storage memory cells (70, 71, 72, 74) connected in a plurality of strings that individually contain a plurality of series connected memory cells (70, 71, 72, 74), the strings being individually connectable at first and second ends thereof to respective first and
second voltage sources and having word lines extending in a direction across the plurality of strings to individually define pages of memory cells (70, 71, 72, 74), and
a controller connected with the charge storage memory cells (70, 71, 72, 74) and that operates to:
identify the memory cells (70, 71, 72, 74) of the strings to be in either a first group (71, 72) or a second group (70, 74),
recognize when, in response to a command, data are read from memory cells of the first group (71, 72) but not at least some of the second group (70, 74),
in response to such a recognition, scrub read data from at least some of the unread memory cells of the second group (70, 74),
thereafter measure a number of errors in the data read from memory cells of the second group (70, 74),
thereafter determine from the number of measured data errors whether a refresh of the scrub read data is necessary, and
if so, refresh the data of memory cells in both of the first (71, 72) and second groups (70, 74)
**CHARACTERISED IN THAT**:
the first and second groups are predefined in the memory system such that the memory cells of the second group (70, 74) are adjacent to either the source select transistor (77) or the drain select transistor (79) and the memory cells of the first group (71, 72) are the complement of the second group.

10. The memory system of Claim 9, wherein the plurality of strings are formed in groups of memory cells (70, 71, 72, 74) that individually contain a plurality of the pages of memory cells (70, 71, 72, 74), the memory cells (70, 71, 72, 74) of individual groups being erasable concurrently.

11. The memory system of Claim 9 or 10, wherein the controller further operates to:
determine the level of quality of the read data by determining a number of bit errors in the scrub read data, and
determine the level of quality of the scrub data by comparing the number of bit errors with a preset threshold.

12. The memory system of Claim 10 or Claim 11, wherein the controller further operates to:
determine a level of quality of the scrub read data by determining a first number of bit errors in at least some of the command read data and a second number of bit errors in at least some of the scrub read data, and
determine the level of quality of the scrub read data by comparing the first and second numbers of bit errors.

13. The memory system of any of Claims 9 to 12, wherein the controller further operates to:
compare the first and second numbers of bit errors by calculating a ratio of the first and second numbers, and
thereafter comparing the ratio with a pre-defined threshold.

## Patentansprüche

1. Verfahren zum Betreiben eines umprogrammierbaren nichtflüchtigen Speichersystems mit einer Anordnung von Speicherzellen, die zu NAND-Ketten organisiert sind, und einem damit verbundenen Systemcontroller, wobei die Speicherzellen individuell jeweils einen Transistor (70, 71, 72, 74) mit einer Source und einem Drain, einem Ladungsspeicherelement und einem Steuer-Gate einschließen, wobei jede NAND-Kette ein Source-Ende und ein Drain-Ende hat und durch eine Reihe von Ladungsspeichertransistoren (70, 71, 72, 74) gebildet wird, die durch das Drain einer Zelle (70, 71, 72, 74) mit der Source des angrenzenden Ladungsspeichertransistors (70, 71, 72, 74) verkettet sind und durch einen Source-Auswahltransistor (77) zum Source-Ende schaltbar sind und durch einen Drain-Auswahltransistor (79) zum Drain-Ende schaltbar sind, wobei das Verfahren umfasst: im Speichersystem erfolgendes
Identifizieren der Speicherzellen (70, 71, 72, 74) der NAND-Ketten als entweder in einer ersten Gruppe (71, 72) oder einer zweiten Gruppe (70, 74) befindlich,
Erkennen, wenn als Antwort auf einen Befehl Daten aus Speicherzellen der ersten Gruppe (71, 72), aber nicht aus mindestens einigen der zweiten Gruppe (70, 74) gelesen werden,
als Antwort auf ein solches Erkennen erfolgendes Reinigungslesen von Daten aus mindestens einigen der ungelesenen Speicherzellen der zweiten Gruppe (70, 74),
danach Messen einer Anzahl von Fehlern in den aus Speicherzellen der zweiten Gruppe (70, 74) gelesenen Daten,
danach Bestimmen aus der Anzahl von gemessenen Datenfehlern, ob eine Auffrischung der reinigungsgelesenen Daten nötig ist, und
wenn ja, Auffrischen der Daten von Speicherzellen in sowohl der ersten (71, 72) als auch der zweiten Gruppe (70, 74),
**dadurch gekennzeichnet, dass**
die erste und zweite Gruppe so vordefiniert sind, dass die Speicherzellen der zweiten Gruppe (70, 74) entweder an den Source-Auswahltransistor (77) oder den Drain-Auswahltransistor (79) angrenzen und die Speicherzellen der ersten Gruppe (71, 72) die Ergänzung zur zweiten Gruppe sind.

2. Verfahren nach Anspruch 1, worin das Speichern durch paralleles Programmieren einer Seite von Speicherzellen (70, 71, 72, 74) mit einer gemeinsamen Wortleitung, die sich über eine Vielzahl von NAND-Ketten erstreckt, erfolgt.

3. Verfahren nach Anspruch 1 oder 2, worin die Anordnung in Blöcke geteilt ist, die individuell eine Vielzahl von NAND-Ketten einschließen, deren Speicherzellen (70, 71, 72, 74) gleichzeitig löschbar sind, bevor Daten darin programmiert werden, und die erste (71, 72) und zweite (70, 74) Gruppe von Speicherzellen sich in einem gegebenen Block von Speicherzellen befinden.

4. Verfahren nach einem der vorhergehenden Ansprüche, worin das Bestimmen, ob Daten im Block aufzufrischen sind, einschließt: Vergleichen der Anzahl von Bitfehlern mindestens der reinigungsgelesenen Daten mit einem vorgegebenen Schwellenwert.

5. Verfahren nach einem der vorhergehenden Ansprüche, zusätzlich umfassend: Messen einer Anzahl von Bitfehlern in den aus einer oder mehreren Seiten des gegebenen Blocks befehlsgelesenen Daten, und worin das Bestimmen, ob Daten im Block aufzufrischen sind, einschließt: Vergleichen der Anzahl von Bitfehlern in den reinigungsgelesenen Daten mit der Anzahl von Bitfehlern in den befehlsgelesenen Daten.

6. Verfahren nach Anspruch 5, worin das Vergleichen der Datenbitfehler einschließt: Berechnen eines Verhältnisses der Anzahl von Bitfehlern in den reinigungsgelesenen Daten und der Anzahl von Bitfehlern in den befehlsgelesenen Daten und danach Vergleichen des Verhältnisses mit einem vordefinierten Schwellenwert.

7. Verfahren nach einem der vorhergehenden Ansprüche, worin der Befehl, Daten aus Speicherzellen der ersten Gruppe (71, 72), aber nicht aus mindestens einigen der zweiten Gruppe (70, 74) zu lesen, von außerhalb des Speichersystems empfangen wird.

8. Verfahren nach einem der Ansprüche 1 bis 6, worin der Befehl, Daten aus Speicherzellen der ersten Gruppe (71, 72), aber nicht aus mindestens einigen der zweiten Gruppe (70, 74) zu lesen, innerhalb des Speichersystems erzeugt wird.

9. Umprogrammierbares nichtflüchtiges Speichersystem, umfassend:
eine Vielzahl von Ladungsspeicher-Speicherzellen (70, 71, 72, 74), die in einer Vielzahl von Ketten verbunden sind, die individuell eine Vielzahl von in Reihe geschalteten Speicherzellen (70, 71, 72, 74) enthalten, wobei die Ketten an das erste und zweite Ende derselben mit jeweiligen ersten und zweiten Spannungsquellen individuell verbindbar sind und Wortleitungen haben, die sich in einer Richtung quer zur Vielzahl von Ketten erstrecken, um individuell Seiten von Speicherzellen (70, 71, 72, 74) zu definieren, und
einen Controller, der mit der Vielzahl von Ladungsspeicher-Speicherzellen (70, 71, 72, 74) verbunden ist und arbeitet, um:
die Speicherzellen (70, 71, 72, 74) der Ketten als entweder in einer ersten Gruppe (71, 72) oder einer zweiten Gruppe (70, 74) befindlich zu identifizieren,
zu erkennen, wenn als Antwort auf einen Befehl Daten aus Speicherzellen der ersten Gruppe (71, 72), aber nicht aus mindestens einigen der zweiten Gruppe (70, 74) gelesen werden,
als Antwort auf ein solches Erkennen Daten aus mindestens einigen der ungelesenen Speicherzellen der zweiten Gruppe (70, 74) reinigungszulesen,
danach eine Anzahl von Fehlern in den aus Speicherzellen der zweiten Gruppe (70, 74) gelesenen Daten zu bestimmen,
danach aus der Anzahl von gemessenen Datenfehlern zu bestimmen, ob eine Auffrischung der reinigungsgelesenen Daten nötig ist, und
wenn ja, die Daten von Speicherzellen in sowohl der ersten (71, 72) als auch der zweiten Gruppe (70, 74) aufzufrischen,
**dadurch gekennzeichnet, dass**
die erste und zweite Gruppe im Speichersystem so vordefiniert sind, dass die Speicherzellen der zweiten Gruppe (70, 74) entweder an den Source-Auswahltransistor (77) oder den Drain-Auswahltransistor (79) angrenzen und die Speicherzellen der ersten Gruppe (71, 72) die Ergänzung zur zweiten Gruppe sind.

10. Speichersystem nach Anspruch 9, worin die Vielzahl von Ketten in Gruppen von Speicherzellen (70, 71, 72, 74) gebildet sind, die individuell eine Vielzahl der Seiten von Speicherzellen (70, 71, 72, 74) enthalten, wobei die Speicherzellen (70, 71, 72, 74) individueller Gruppen gleichzeitig löschbar sind.

11. Speichersystem nach Anspruch 9 oder 10, worin der Controller ferner arbeitet, um:
das Qualitätsniveau der gelesenen Daten durch Bestimmen einer Anzahl von Bitfehlern in den reinigungsgelesenen Daten zu bestimmen, und
das Qualitätsniveau der reinigungsgelesenen Daten durch Vergleichen der Anzahl von Bitfehlern mit einem vorgegebenen Schwellenwert zu bestimmen.

12. Speichersystem nach Anspruch 10 oder 11, worin der Controller ferner arbeitet, um:
ein Qualitätsniveau der reinigungsgelesenen Daten durch Bestimmen einer ersten Anzahl von Bitfehlern in mindestens einigen der befehlsgelesenen Daten und einer zweiten Anzahl von Bitfehlern in mindestens einigen der reinigungsgelesenen Daten zu bestimmen, und
das Qualitätsniveau der reinigungsgelesenen Daten durch Vergleichen der ersten und der zweiten Anzahl von Bitfehlern zu bestimmen.

13. Speichersystem nach einem der Ansprüche 9 bis 12, worin der Controller ferner arbeitet, um:
die erste und die zweite Anzahl von Bitfehlern durch Berechnen eines Verhältnisses der ersten und der zweiten Anzahl zu vergleichen, und
danach das Verhältnis mit einem vordefinierten Schwellenwert zu vergleichen.

## Revendications

1. Procédé de fonctionnement d'un système de mémoire non volatile reprogrammable qui comporte un réseau de cellules de mémoire organisées selon des chaînes NON-ET et un contrôleur système qui lui est connecté, les cellules de mémoire incluant individuellement un transistor (70, 71, 72, 74) qui comporte une source et un drain, un élément de stockage de charges et une grille de commande, chaque chaîne NON-ET comportant une extrémité de source et une extrémité de drain et étant formée par une série de transistors de stockage de charges (70, 71, 72, 74) connectés en guirlande au moyen du drain d'une cellule (70, 71, 72, 74) à la source du transistor de stockage de charges adjacent (70, 71, 72, 74) et commutables sur l'extrémité de source au moyen d'un transistor de sélection de source (77) et commutables sur l'extrémité de drain au moyen d'un transistor de sélection de drain (79), le procédé comprenant, dans le système de mémoire :
l'identification des cellules de mémoire (70, 71, 72, 74) des chaînes NON-ET qui sont soit dans un premier groupe (71, 72), soit dans un second groupe (70, 74),
la reconnaissance de lorsque, en réponse à une commande, des données sont lues à partir de cellules de mémoire du premier groupe (71, 72) mais pas à partir d'au moins certaines cellules de mémoire du second groupe (70, 74) ;
en réponse à cette reconnaissance, la lecture pour nettoyage de données dans au moins certaines des cellules de mémoire non lues du second groupe (70, 74),
ensuite, la mesure d'un nombre d'erreurs dans les données lues à partir de cellules de mémoire du second groupe (70, 74),
ensuite, la détermination, à partir du nombre d'erreurs de données mesurées, selon laquelle un rafraîchissement des données lues de nettoyage est nécessaire, et
si la réponse est oui, le rafraîchissement des données de cellules de mémoire dans à la fois les premier (71, 72) et second (70, 74) groupes,
**caractérisé en ce que** :
les premier et second groupes sont prédéfinis de telle sorte que les cellules de mémoire du second groupe (70, 74) soient adjacentes soit au transistor de sélection de source (77), soit au transistor de sélection de drain (79) et que les cellules de mémoire du premier groupe (71, 72) soient le complément du second groupe.

2. Procédé selon la revendication 1, dans lequel ledit stockage est effectué par programmation en parallèle d'une page de cellules de mémoire (70, 71, 72, 74) à l'aide d'une ligne de mot commune qui s'étend sur une pluralité de chaînes NON-ET.

3. Procédé selon la revendication 1 ou la revendication 2, dans lequel le réseau est divisé selon des blocs qui incluent individuellement une pluralité de chaînes NON-ET dont des cellules de mémoire (70, 71, 72, 74) sont effaçables simultanément avant la programmation de données dedans, et les premier (71, 72) et second (70, 74) groupes de cellules de mémoire sont situés dans un bloc donné de cellules de mémoire.

4. Procédé selon l'une quelconque des revendications précédentes, dans lequel la détermination selon laquelle des données dans le bloc doivent être rafraîchies inclut la comparaison du nombre d'erreurs binaires d'au moins les données lues de nettoyage avec un seuil préétabli.

5. Procédé selon l'une quelconque des revendications précédentes, comprenant de manière additionnelle la mesure d'un nombre d'erreurs binaires dans les données lues de commande qui sont lues à partir d'une ou de plusieurs page(s) du bloc donné, et dans lequel la détermination selon laquelle des données dans le bloc doivent être rafraîchies inclut la comparaison du nombre d'erreurs binaires dans les données lues de nettoyage avec le nombre d'erreurs binaires dans les données lues de commande.

6. Procédé selon la revendication 5, dans lequel la comparaison des erreurs binaires de données inclut le calcul d'un ratio du nombre d'erreurs binaires dans les données lues de nettoyage et du nombre d'erreurs binaires dans les données lues de commande, puis la comparaison du ratio avec un seuil prédéfini.

7. Procédé selon l'une quelconque des revendications précédentes, dans lequel la commande pour lire des données à partir de cellules de mémoire du premier groupe (71, 72) mais pas à partir d'au moins certaines cellules de mémoire du second groupe (70, 74) est reçue depuis l'extérieur du système de mémoire.

8. Procédé selon l'une quelconque des revendications 1 à 6, dans lequel la commande pour lire des données à partir de cellules de mémoire du premier groupe (71, 72) mais pas à partir d'au moins certaines cellules de mémoire du second groupe (70, 74) est générée à l'intérieur du système de mémoire.

9. Système de mémoire non volatile reprogrammable, comprenant :
une pluralité de cellules de mémoire de stockage de charges (70, 71, 72, 74) qui sont connectées selon une pluralité de chaînes qui contiennent individuellement une pluralité de cellules de mémoire connectées en série (70, 71, 72, 74), les chaînes pouvant être connectées individuellement au niveau de leurs première et seconde extrémités à des première et seconde sources de tension respectives et comportant des lignes de mot qui s'étendent dans une direction qui croise la pluralité de chaînes afin de définir individuellement des pages de cellules de mémoire (70, 71, 72, 74), et
un contrôleur connecté aux cellules de mémoire de stockage de charges (70, 71, 72, 74) et qui fonctionne pour :
identifier les cellules de mémoire (70, 71, 72, 74) des chaînes qui sont soit dans un premier groupe (71, 72), soit dans un second groupe (70, 74)
reconnaître lorsque, en réponse à une commande, des données sont lues à partir de cellules de mémoire du premier groupe (71, 72) mais pas à partir d'au moins certaines cellules de mémoire du second groupe (70, 74) ;
en réponse à cette reconnaissance, lire pour nettoyage des données à partir d'au moins certaines des cellules de mémoire non lues du second groupe (70, 74),
ensuite, mesurer un nombre d'erreurs dans les données lues à partir de cellules de mémoire du second groupe (70, 74),
ensuite, déterminer, à partir du nombre d'erreurs de données mesurées, si oui ou non un rafraîchissement des données lues de nettoyage est nécessaire, et
si la réponse est oui, rafraîchir les données de cellules de mémoire dans à la fois les premier (71, 72) et second (70, 74) groupes,
**caractérisé en ce que** :
les premier et second groupes sont prédéfinis dans le système de mémoire de telle sorte que les cellules de mémoire du second groupe (70, 74) soient adjacentes soit au transistor de sélection de source (77), soit au transistor de sélection de drain (79) et que les cellules de mémoire du premier groupe (71, 72) soient le complément du second groupe.

10. Système de mémoire selon la revendication 9, dans lequel la pluralité de chaînes est formée selon des groupes de cellules de mémoire (70, 71, 72, 74) qui contiennent individuellement une pluralité des pages de cellules de mémoire (70, 71, 72, 74), les cellules de mémoire (70, 71, 72, 74) de groupes individuels pouvant être effacées simultanément.

11. Système de mémoire selon la revendication 9 ou 10, dans lequel le contrôleur fonctionne en outre pour :
déterminer le niveau de qualité des données lues en déterminant un nombre d'erreurs binaires dans les données lues de nettoyage, et
déterminer le niveau de qualité des données lues de nettoyage en comparant le nombre d'erreurs binaires avec un seuil préétabli.

12. Système de mémoire selon la revendication 10 ou la revendication 11, dans lequel le contrôleur fonctionne en outre pour :
déterminer un niveau de qualité des données lues de nettoyage en déterminant un premier nombre d'erreurs binaires dans au moins certaines des données lues de commande et un second nombre d'erreurs binaires dans au moins certaines des données lues de nettoyage, et
déterminer le niveau de qualité des données lues de nettoyage en comparant les premier et second nombres d'erreurs binaires.

13. Système de mémoire selon l'une quelconque des revendications 9 à 12, dans lequel le contrôleur fonctionne en outre pour :
comparer les premier et second nombres d'erreurs binaires en calculant un ratio des premier et second nombres, et
comparer ensuite le ratio avec un seuil prédéfini.
